**Europäisches Patentamt**

**European Patent Office**

**Office européen des brevets**

(19)

(11) Veröffentlichungsnummer : **0 132 823**
**B1**

(12) **EUROPÄISCHE PATENTSCHRIFT**

(45) Veröffentlichungstag der Patentschrift :
28.09.88

(51) Int. Cl.⁴ : **G 03 F   1/00**

(21) Anmeldenummer : **84108688.7**

(22) Anmeldetag : **23.07.84**

(54) **Verfahren zum Herstellen von masshaltigen Strukturen mit hohem Aspektverhältnis im 1 Millimikron-Bereich und darunter für die Mikroelektronik und Anwendung dieses Verfahrens zur Herstellung einer Röntgenabsorbermaske.**

(30) Priorität : 27.07.83 DE 3327088
12.06.84 DE 3421773

(43) Veröffentlichungstag der Anmeldung :
13.02.85 Patentblatt 85/07

(45) Bekanntmachung des Hinweises auf die Patenterteilung : 28.09.88 Patentblatt 88/39

(84) Benannte Vertragsstaaten :
AT BE CH DE FR GB IT LI LU NL SE

(56) Entgegenhaltungen :
EP-A- 0 098 472
US-A- 3 975 252
US-A- 4 037 111
US-A- 4 284 678
NAVY TECHNICAL DISCLOSURE BULLETIN, Band 9, Nr. 4, Juni 1984, Seiten 107-109, Washington, US; J.E. SCHEPPELE: "Method of eliminating the adverse effects of positive photo resist processing on plasma/rie etching of Al/Cu"

(73) Patentinhaber : Siemens Aktiengesellschaft Berlin und München
Wittelsbacherplatz 2
D-8000 München 2 (DE)

(72) Erfinder : Schneider-Gmelch, Brigitte, Dipl.-Ing.
Fritz-Kortner-Bogen 42
D-8000 München 83 (DE)
Erfinder : Mathuni, Joseph, Dr. rer. nat., Dipl-Phys.
Balanstrasse 69
D-8000 München 90 (DE)

# 0 132 823

**Beschreibung**

Die Patentanmeldung betrifft ein Verfahren zum Herstellen von maßhaltigen Strukturen mit hohem Aspektverhältnis im 1 μm-Bereich und darunter, wie sie insbesondere für die Fertigung von Masken in der Mikroelektronik verwendet werden, durch Bestrahlen von für Fotonen-, Elektronen-, Röntgen- und Ionenstrahlen empfindlichen Lacken, bei dem die eigentliche zu strukturierende Schicht über aus mindestens drei Metallen oder Metalloxiden bestehender Hilfsschichten mittels Naß- oder Trockenätzprozessen strukturiert wird, sowie die Anwendung dieses Verfahrens zur Herstellung einer Röntgenabsorbermaske.

Ein solches Verfahren ist beispielsweise aus der US-A 3.975.252 bekannt.

Bei der Herstellung von maßhaltigen Submikronstrukturen und Strukturen mit hohem Aspektverhältnis (sehr schmale Stege im Vergleich zur Höhe) werden Ionenstrahlätzprozesse angewendet, wobei sich unter den Strukturen aus für Fotonen-, Elektronen-, Röntgen- und Ionenstrahlen empfindlichen Lacken Schichtfolgen befinden, die entweder direkt oder über Hilfsschichten aus Metallen, Metalloxiden oder metallorganischen Verbindungen strukturiert werden.

Die Strukturierbarkeit der Hilfsschicht ist sehr problematisch, da sie stark von den Prozeßabläufen in der Technologie abhängig ist und damit schwer reproduzierbar ist. An offenen Oberflächen bilden sich nämlich Grenzschichten aus, welche die Selektivität bei den Ätzprozessen sehr negativ beeinflussen. Näheres ist aus einem Aufsatz von Hörz und Fromm aus der Zeitschrift « Vacuum », Band 33, No. 5, (1983), auf den Seiten 265-270 zu entnehmen.

Aus einem Aufsatz von Cantragel in IEEE Transactions on Electron Devices, Vol. ED-22, No. 7, Juli 1975, Seiten 483-486, ist bekannt, zunächst einen dünnen Metallfilm, zum Beispiel aus Titan, Vanadin, Mangan oder Aluminium über der zu ätzenden Schicht aufzubringen und mit Lack zu strukturieren. Dieser strukturierte Metallfilm dient dann selbst als Maskierung für die darunterliegende Schicht. Dabei wird die Tatsache ausgenutzt, daß bei vielen Metallen die Ätzrate des Oxids mit Argon-Ionen wesentlich geringer ist als die des Metalles selbst. Auf diese Weise kann man zunächst, zum Beispiel durch Ionenstrahlätzen mit reinem Argon das entsprechende Metall strukturieren und dann weiter als Maske benutzen, indem man mit einer Mischung aus Argon und Sauerstoff weiterätzt. Das Metalloxid wird dann während des Ätzens an der Oberfläche der Metallmaske gebildet.

Dieses Verfahren hat aber den Nachteil, daß sich die Metallschicht, die als Maske dienen soll, schon vor der Strukturierung, zum Beispiel während der Lagerung der Substrate sowie beim Aufbringen und Ausheizen des Lackes mit einer Oxidschicht bezieht und dadurch den Ätzprozeß erschwert. Die Selektivität gegenüber den verwendeten Lacken (insbesondere PMMA = Polymethylmethacrylat) ist zu gering, um einen Lackschwund zu vermeiden. Dieser führt zu einem Maßverlust und damit zu schrägen und undefinierten Flanken bei der Hilfsschicht, die sich dann ihrerseits nicht maßhaltig übertragen läßt.

Der Erfindung liegt deshalb die Aufgabe zugrunde, ein Verfahren der eingangs genannten Art anzugeben, bei dem diese Nachteile nicht auftreten.

Die erfindungsgemäße Aufgabe wird dadurch gelöst, daß im Anschluß an die Herstellung der zu strukturierenden Schichten bis zum Beginn des Strukturierungsvorganges eine die äußerste Hilfsschicht passivierende zusätzliche Schicht aufgebracht wird. Dabei liegt es im Rahmen des Erfindungsgedankens, daß als Passivierung bei Verwendung von aus Metall oder Metallkombinationen bestehenden Hilfsschichten eine Gold- oder Platinschicht und bei Verwendung einer aus Metalloxiden bestehenden Hilfsschicht eine Kohlenstoffschicht vorgesehen ist. Diese Passivierungsschicht hat die Funktion, offene Grenzflächen gegen chemische Reaktionen, wie zum Beispiel bei Metallen, vor Oxidation, zu schützen, indem sie als Sperrschicht oder als Ätzstop wirkt. Dadurch wird die Lagerung der Substrate, sowie ein Anlagen- oder Verfahrenswechsel wesentlich erleichtert.

Es ist aber auch möglich, anstelle der Gold- oder Platinschicht eine Schicht aus Silber, Palladium oder Kupfer zu verwenden.

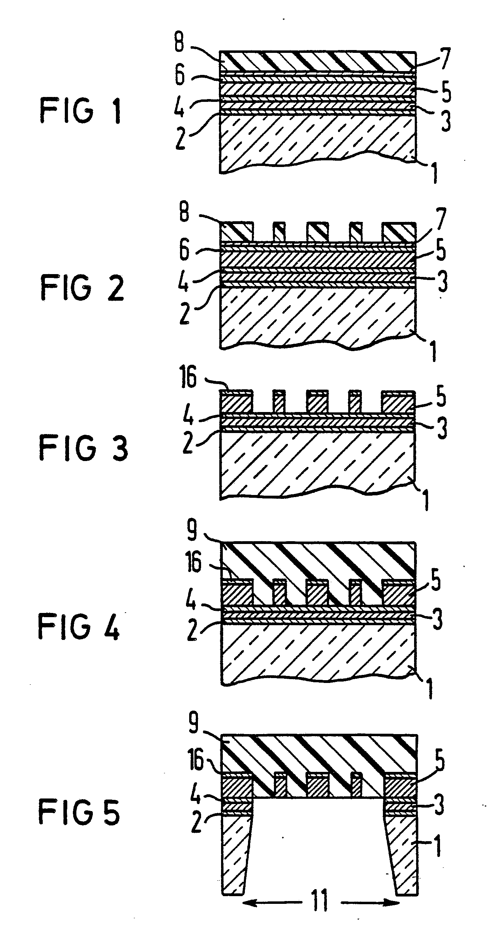

Das Verfahren nach der Lehre der Erfindung wird nachfolgend anhand eines besonders günstigen Ausführungsbeispiels bei der Herstellung einer Röntgenabsorbermaske noch näher beschrieben. Dabei wird auf die Figuren 1 bis 5 Bezug genommen, die im Schnittbild die Verfahrensfolge darstellen.

Figur 1 : Eine zum Beispiel aus Glas bestehende Platte 1 wird mit einem Sandwich-Aufbau bedampft, der alle notwendigen Haft-, Ätzstop-, Absorber-, Hilfs- und Passivierungsschichten enthält, die während des Strukturierens in einer Ionenstrahlätzanlage benötigt werden. Diese sind eine 20 nm dicke erste Titanhaftschicht 2, eine 400 nm dicke erste Goldschicht 3 als Ätzstop bei der Rückseitenätzung des Glasträgers 1 im Transmissionsbereich (11) und die Schichtfolge für die Absorberstrukturierung (4, 5, 6, 7). Diese besteht aus einer 20 nm dicken Haft- und Ätzstop-Schicht 4 (zweite Titanschicht), einer 800 nm dicken Goldabsorberschicht 5 (zweite Goldschicht), einer 70 nm dicken Titanhilfsschicht 6 (dritte Titanschicht) und der 30 nm dicken erfindungsgemäßen, zum Beispiel aus Gold bestehenden Passivierungsschicht 7 (dritte Goldschicht). Die Goldpassivierungsschicht 7 verhindert vor der Strukturierung die ganze oder teilweise Umwandlung der dritten Titanschicht 6 in Titanoxid. Auf die mit der Schichtenfolge (2, 3, 4, 5, 6, 7) versehene Glasplatte 1 wird ein für Elektronenstrahlen empfindlicher Lack (PMMA) in einer Schichtdicke von 1000 nm aufgebracht.

Das durch Elektronenstrahlschreiben erzeugte Lackmuster 8 (siehe Figur 2) wird anschließend in einem vierstufigen Ätzprozeß in einer Ionenstrahlätzanlage geätzt. Die Goldpassivierungsschicht 7 und die Titanhilfsschicht 6 werden physikalisch mittels Argonionenbeschuß strukturiert. Durch Zugabe von Sauerstoff wird während des nächsten Ätzschrittes die Titanhilfsschicht 6 gezielt in eine Titanoxidschicht (16) umgewandelt, um eine höhere selektive Ätzrate der darunterliegenden Schicht 5 zu erreichen, um diese maßhaltig strukturieren zu können. Die Zugabe von Sauerstoff führt zu einem reaktiven Ätzprozeß. Durch die Zugabe von Sauerstoff erniedrigt sich die Ätzrate von Gold um 15 % und die von Titan um 95 % bei gleichbleibenden Anlagenparametern.

Die Figur 3 zeigt die Anordnung nach der Entfernung der Lackmaske 8 und der Strukturen der Goldschicht 7 und nach der Oxidation der Titanhilfsmaske (6) zu Titanoxid (16), sowie der Strukturierung der Goldabsorberschicht 5.

Die Parameter beim Ätzen sind aus der folgenden Tabelle ersichtlich.

| Ätzschritt | Ätzwinkel | Ätzzeit | Ätzgas |
|---|---|---|---|
| I | 0° | 5 Min. | 3 sccm Argon/Min. |
| II | 30° | 15 Min. | |
| III | 30° | 15 Min. | 3 sccm Argon/Min. |
| IV | 0° | 10 Min. | + 5 sccm $O_2$/Min. |

Beschleunigungsenergie : 700 eV
Ionenstromdichte 0.5 mA/cm$^2$

Beim ersten Ätzschritt wird die Passivierungsschicht 7 beseitigt, beim zweiten Ätzschritt die Titanhilfsschicht 6 strukturiert. Hier wird bereits in die Goldschicht 5 hineingeätzt, um den Abschattungseffekt in Gold und nicht im Titan (6) zu haben. Damit erhält man senkrechte Kanten der Titanschicht 6. Beim dritten Ätzschritt wird Sauerstoff zugegeben und die Titanschicht 6 in eine Titanoxidschicht 16 umgewandelt. Der restliche Lack (8) verschwindet sehr schnell, so daß die dünne Titanoxidschicht 16 als alleinige Ätzmaske dient. Das Ätzen erfolgt bei einem Ätzwinkel von 30°. Der Abschattungseffekt wird durch die geringe Maskenhöhe verringert. Der vierte Ätzschritt erfolgt bei einem Winkel von 0°, um auch noch in schmalen Gräben zu ätzen und den Fuß der Goldschicht 5 beseitigen zu können.

Die Schwankungen in der Reproduzierbarkeit der Ätzung liegen unter 10 % bei Strukturbreiten von 0,5 ,3mm (Absorberschichtdicke 800 nm).

Wie aus Figur 4 ersichtlich ist, wird vor der Rückseitenätzung auf die mit Strukturen (5, 6) versehene Oberfläche (2, 3, 4) des Substrates 1 eine Polyimidschicht 9 von 2000-5000 nm Dicke aufgebracht.

Figur 5 zeigt die Anordnung nach der Rückseitenätzung, das heißt, nach Entfernung der Unterlagenplatte 1, sowie der Titanschicht 2, der Goldschicht 3 und der Titanschicht 4 im Transmissionsbereich 11. Die 400 nm dicke Goldschicht 3 bildet einen guten Ätzstop für die Glasätzung des Maskenträgers (1) im Transmissionsbereich 11. Die Ätzung wird durchgeführt mit Argon als Ätzgas in einer Ionenstrahlätzanlage bei einer Ionenstromdicke von 0,2 mA/cm$^2$ und einer Beschleunigungsspannung von 500 eV.

Das Verfahren nach der Lehre der Erfindung ist neben Titan auch für andere metallische Hilfsmasken wie zum Beispiel Hafnium, Zirkon, Vanadin, Chrom, Mangan, Aluminium, Niob und Tantal anwendbar.

Als Ätzstopschicht lassen sich Gold, Platin, Silber, Palladium, Kupfer oder Kohlenstoff speziell beim reaktiven Trockenätzen von Metalloxiden, wie zum Beispiel Aluminiumoxid, Siliziumoxid, Titanoxid, Wolframoxid, anwenden.

Ein weiteres Anwendungsgebiet dieser Schicht ist in ihrer Funktion als Sperrschicht gegen das Eindringen von Entwicklerlösungen auf metallorganischen oder organischen Unterlagen, zum Beispiel bei ihrer Verwendung in Mehrlagenresistsystemen :
a) auf den anorganischen Zwischenschichten
b) zwischen 2 Photolacken oder
c) zwischen oberem Photolack und darunter liegender organischer Schicht (zum Beispiel aus Polyimid), zu sehen.

**Patentansprüche**

1. Verfahren zum Herstellen von maßhaltigen Strukturen mit hohem Aspektverhältnis im 1 μm-Bereich und darunter, wie sie insbesondere für die Fertigung von Masken in der Mikroelektronik verwendet werden, durch Bestrahlen von für Fotonen-, Elektronen-, Röntgen- und Ionenstrahlen empfindlichen Lacken, bei dem die eigentliche zu strukturierende Schicht über aus mindestens drei Metallen oder Metalloxiden bestehenden Hilfsschichten mittels Naß- oder Trockenätzprozessen strukturiert wird, dadurch gekennzeichnet, daß im Anschluß an die Herstellung der zu strukturierenden Schichten (2, 3, 4, 5, 6) bis zum Beginn des Strukturierungsvorganges eine die äußerste Hilfsschicht (6) passivierende zusätzliche Schicht (7) aufgebracht wird.

2. Verfahren nach Anspruch 1, dadurch gekennzeichnet, daß als Passivierung bei Verwendung von aus Metall oder Metallkombinationen bestehenden Hilfsschichten (6) eine Gold-, Silber-, Palladium-, Kupfer- oder Platin-Schicht (7) vorgesehen ist.

3. Verfahren nach Anspruch 1, dadurch gekennzeichnet, daß als Passivierung bei Verwendung einer aus Metalloxiden bestehenden Hilfsschicht (6) eine Kohlenstoff-Schicht (7) vorgesehen ist.

4. Verfahren zum Herstellen einer Röntgenabsorbermaske nach Anspruch 1 bis 4, gekennzeichnet durch den Ablauf des Aufbringens folgender Metallschichten auf einer als Substrat dienenden, aus Glas, Quarz oder Silizium bestehenden Platte (1) :

a) einer als Haftschicht dienenden ersten Titanschicht (2),

b) einer als Ätzstop bei der Rückseitenätzung der Glasplatte (1) dienenden ersten Goldschicht (3),

c) einer als Haft- und/oder Ätzstopschicht dienenden zweiten Titanschicht (4),

d) einer zweiten, als Absorberschicht dienenden Goldschicht (5),

e) einer dritten, als Hilfsstrukturierungsschicht dienenden Titanschicht (6) und

f) einer als Passivierungsschicht dienenden dritten Goldschicht (7), weiterhin gekennzeichnet durch

g) das Aufbringen eines für Elektronen-, Fotonen-, Ionen- oder Röntgenstrahlen empfindlichen Lackes (8),

h) Belichtung und Entwicklung des Lackes (8) entsprechend der gewünschten Struktur,

i) Strukturierung der Goldpassivierungsschicht (7), der Titanhilfsschicht (6) und Anätzen der Goldabsorberschicht (5) durch unterschiedlich langes und unterschiedlich gerichtetes reaktives Ionenstrahlätzen mit Argon als Ätzgas,

j) Entfernen der Lackmaske (8), der Goldpassivierungsschicht (7), Aufoxidation der Titanhilfsschicht (6) und Strukturieren der Goldabsorptionsschicht (5) mit Titanoxid als Maskierung durch unterschiedlich langes und unterschiedlich gerichtetes reaktives Ionenstrahlätzen mit Argon und Sauerstoff als Ätzgas,

k) Aufbringen einer Polyimidschicht (9) auf der strukturierten Oberfläche,

l) Entfernen der Bereiche des Substrates (1), der ersten und zweiten Titanschicht (2, 4) sowie der ersten Goldschicht (3) im Transmissionsbereich (11) durch Rückseitenätzung in der Ionenstrahlätzanlage mit Argon als Ätzgas.

5. Verfahren nach Anspruch 4, dadurch gekennzeichnet, daß anstelle von Gold als Passivierungsschicht (7) Platin, Silber, Palladium oder Kupfer verwendet wird.

6. Verfahren nach Anspruch 4 und/oder 5, dadurch gekennzeichnet, daß anstelle von Titan als Hilfsschicht (6) eine aus Hafnium, Zirkon, Vanadin, Chrom, Mangan, Aluminium, Niob oder Tantal bestehende Metallschicht verwendet wird.

7. Verfahren nach Anspruch 1 bis 6, dadurch gekennzeichnet, daß die Dicke der Passivierungsschicht (7) aus Platin, Palladium, Silber oder Gold auf einen Bereich von 20 bis 50 nm und die Dicke der Hilfsschicht (6) auf einen Bereich von 50 bis 100 nm eingestellt wird.

8. Verfahren nach Anspruch 1 bis 6, dadurch gekennzeichnet, daß die Dicke der Passivierungsschicht (7) aus Kupfer auf einen Bereich von 20 bis 100 nm und die Dicke der Hilfsschicht (6) auf einen Bereich von 50 bis 200 nm eingestellt wird.

## Claims

1. A process for the production of precisely dimensioned structures with a high aspect ratio in the region of 1 ,3mm and less, such as are used in particular for the production of masks in micro-electronics, by the irradiation of lacquer layers which are sensitive to photon, electron, X-ray and ion beams, in which the actual layer which is to be structured is structured by means of wet or dry etching procedures by way of auxiliary layers which consist of at least three metals or metal oxides, characterised in that following the production of the layers (2, 3, 4, 5, 6) which are to be structured, until the start of the structuring procedure, an additional layer (7) which passivates the outermost auxiliary layer (6) is applied.

2. A process as claimed in Claim 1, characterised in that when auxiliary layers (6) consisting of metal or metal combinations are used, a gold, silver, palladium, copper, or platinum layer (7) is provided as the passivating layer.

3. A process as claimed in Claim 1, characterised in that when an auxiliary layers (6) consisting of metal oxides is used, a carbon layer (7) is provided as the passivating layer.

4. A process for the production of an X-ray absorber mask as claimed in Claim 1 to 4, characterised by the sequence of the application of the following metal layers on a plate (1) which serves as substrate and which consists of glass, quartz crystal, or silicon :

a) a first titanium layer (2) which serves as bonding layer,

b) a first gold layer (3) which serves as etch-stop layer for the rear-side etching of the glass plate (1),

c) a second titanium layer (4) which serves as bonding layer and/or etch-stop layer,

d) a second gold layer (5) which serves as absorber layer,

e) a third titanium layer (6) which serves as auxiliary structuring layer, and

f) a third gold layer (7) which serves as passivating layer, further characterised by

g) the application of a lacquer layer (8) which is sensitive to electron, photon, ion, or X-ray beams,

h) the exposure and development of the lacquer layer (8) in accordance with the desired structure,

i) the structuring of the gold passivating layer (7), the titanium auxiliary layer (6) and the etching of the gold absorber layer (5) by reactive ion beam etching, of differing length and with differing directions, using argon as etching gas,

j) removal of the lacquer mask (8), the gold passivating layer (7), the application by oxidation of the titanium auxiliary layer (6), and the structuring of the gold absorption layer (5) using titanium oxide as mask by reactive ion beam etching, of differing length and with differing directions, using argon and oxygen as etching gas,

k) application of a polyimide layer (9) to the structured surface,

l) removal of the regions of the substrate (1), the first and second titanium layers (2, 4) and the first gold layer (3) in the transmission zone (11) by rear-side etching in an ion beam etching system using argon as etching gas.

5. A process as claimed in Claim 4, characterised in that platinum, silver, palladium, or copper, is used in place of gold as the passivating layer (7).

6. A process as claimed in Claim 4 or 5, characterised in that a metal layer consisting of hafnium, zirconium, vanadium, chromium, manganese, aluminium, niobium, or tantalum is used in place of titanium as auxiliary layer (6).

7. A process as claimed in Claim 1 to 6, characterised in that the thickness of the passivating layer (7) which consists of platinum, palladium, silver, or gold is set in a range of 20 to 50 nm and the thickness of the auxiliary layer (6) is set in a range of 50 to 100 nm.

8. A process as claimed in Claim 1 to 6, characterised in that the thickness of the copper passivating layer (7) is set in a range of 20 to 100 nm and the thickness of the auxiliary layer (6) is set in a range of 50 to 200 nm.

## Revendications

1. Procédé pour la fabrication de structures à dimensions exactes et à proportion d'aspect élevée, dans la plage de 1 millimicron et en dessous, telles qu'elles sont utilisées, en particulier, pour la fabrication de masques pour la micro-électronique, par irradiation de vernis sensibles à des rayons photoniques, à des rayons électroniques, à des rayons X et à des rayons ioniques, du type dans lequel la couche proprement dite qui est à structurer est structurée à l'aide de procédés de corrosion par voie humide ou par voie sèche, par l'intermédiaire d'au moins trois couches auxiliaires constituées par des métaux ou par des oxydes métalliques, caractérisé qu'à la suite de la préparation des couches à structurer (2, 3, 4, 5, 6) et jusqu'au début du processus de structuration, on dépose une couche supplémentaire (7) de passivation de la couche auxiliaire la plus extérieure (6).

2. Procédé selon la revendication 1, caractérisé par le fait que l'on prévoit pour la passivation, dans le cas de l'utilisation de couches auxiliaires (6) constituées par un métal ou par des combinaisons de métaux, une couche (7) en or, en argent, en palladium, en cuivre ou en platine.

3. Procédé selon la revendication 1, caractérisé par le fait que l'on prévoit pour la passivation, dans le cas d'une couche auxiliaire (6) constituée par des oxydes métalliques, une couche de carbone (7).

4. Procédé pour la fabrication d'un masque d'absorption de rayons X, selon l'une des revendications 1 à 4, caractérisé par le processus du dépôt des couches métalliques suivantes sur une plaque (1) qui sert de substrat et qui est constituée par du verre, du quartz ou du silicium :

a) une première couche de titane (2) qui sert de couche d'adhérence ;

b) une première couche d'or (3) qui sert de couche d'arrêt de la corrosion, lors de la corrosion du côté postérieur de la plaque de verre (1) ;

c) une seconde couche de titane (4) qui sert de couche d'adhérence et/ou de couche d'arrêt de la corrosion ;

d) une seconde couche d'or (5) qui sert de couche d'absorption ;

e) une troisième couche de titane (6) qui sert de couche auxiliaire de structuration ; et

f) une troisième couche d'or (7) qui sert de couche de passivation ;

caractérisé, en outre, par

g) le dépôt d'un vernis (8) qui est sensible aux rayons électroniques, aux rayons photoniques, aux rayons ioniques ou aux rayons X ;

h) irradiation et développement du vernis (8) en fonction de la structure souhaitée ;

i) structuration de la couche de passivation en or (7), de la couche auxiliaire de titane (6) et corrosion de la couche d'absorption en or (5) par corrosion ionique réactive, de durée différente et dirigée différemment, avec de l'argon comme gaz de corrosion ;

j) suppression du masque de vernis (8), de la couche de passivation en or (7), oxydation de la couche auxiliaire de titane (6) et structuration de la couche d'absorption en or (5) avec de l'oxyde de titane en tant que masque, par corrosion aux rayons ioniques réactif, de durée différente et de direction différente, à l'aide d'argon ou d'oxygène comme gaz de corrosion ;

k) dépôt d'une couche de polyimide (9) sur la surface structurée ;

l) suppression des zones du substrat (1), de la première et de la seconde couches de titane (2, 4) ainsi que de la première couche en or (3), dans la zone de transmission (11), par une corrosion du côté postérieur, dans l'installation de corrosion aux rayons ioniques, avec l'argon comme gaz de corrosion.

5. Procédé selon la revendication 4, caractérisé par le fait qu'à la place de l'or comme couche de passivation (7), on utilise le platine, l'argent, le palladium ou le cuivre.

6. Procédé selon la revendication 4 et/ou 5, caractérisé par le fait qu'à la place du titane comme couche auxiliaire (6), on utilise une couche métallique qui est constituée par de l'hafnium, du zircon, du vanadium, du chrome, du manganèse, de l'aluminium, du niobium ou de tantale.

7. Procédé selon l'une des revendications 1 à 6, caractérisé par le fait que l'épaisseur de la couche de passivation (7) en platine, en palladium, en argent ou en or, est ajustée sur une plage de 20 à 50 nm et l'épaisseur de la couche auxiliaire (6) est ajustée à une plage de 50 à 100 nm.

8. Procédé selon l'une des revendications 1 à 6, caractérisé par le fait que l'épaisseur de la couche de passivation (7) en cuivre, est ajustée sur une plage de 20 à 100 nm et l'épaisseur de la couche auxiliaire (6) est ajustée à une plage de 50 à 200 nm.

0 132 823

FIG 1

FIG 2

FIG 3

FIG 4

FIG 5